# FASCICULE DE BREVET EUROPEEN

(11) **EP 1 106 771 B1**
(45) Date de publication et mention de la délivrance du brevet: **02.03.2005**
(21) Numéro de dépôt: 00403405.4
(22) Date de dépôt: 05.12.2000
(51) Int. Cl.: E06B 3/66, E06B 3/54, H02G 3/22, H01L 31/048

(54) **Element de construction avec un passage de fils et procédé pour sa fabrication.**
Bauelement mit einer Kabeldurchführung sowie Herstellungsverfahren für dasselbe
Construction element with a passage for cables and process for its production

(30) Priorité: 07.12.1999 DE 19958879
(43) Date de publication de la demande: 13.06.2001
(73) Titulaire: SAINT-GOBAIN GLASS FRANCE, 92400 Courbevoie (FR)
(72) Inventeur: Erban, Christof, 52134 Herzogenrath (DE); Hermens, Ulrich, 52078 Aachen (DE)
(74) Mandataire: Cardin, Elise

(56) Documents cités:
- EP-A- 0 301 617
- DE-A- 4 101 277
- DE-B- 1 278 292
- DE-U- 29 621 302

## Description

L'invention se rapporte à un élément de construction plat avec un passage de fils présentant les caractéristiques du préambule de la revendication 1.

Par le document DE 295 09 193 U1, on connaît un élément de construction plat avec des éléments fonctionnels électriques, en particulier des cellules solaires, dont les fils de raccordement électrique sont menés vers l'extérieur hors de l'élément de construction. L'élément de construction constitue globalement un vitrage isolant composé de deux vitres transparentes assemblées au moyen d'un espaceur en forme de cadre. Une première vitre de celui-ci est une vitre composite à plusieurs feuilles, à l'intérieur de laquelle sont disposés les éléments fonctionnels électriques. En particulier, les cellules solaires sont noyées dans une couche de résine de moulage, qui remplit l'écartement entre deux vitres parallèles.

Les fils de raccordement précités sont menés hors du composite à travers un trou foré ou fraisé, qui est prévu dans la vitre extérieure du composite assemblée avec l'espaceur à l'extérieur de l'espace compris entre les vitres du vitrage circonscrit par l'espaceur, à proximité du bord de l'élément de construction. Les fils de raccordement sont ensuite conduits à travers un trou foré de la seconde vitre du vitrage isolant, qui se trouve également à l'extérieur de l'espace compris entre les vitres du vitrage circonscrit par l'espaceur, à proximité de l'arête extérieure de la vitre. L'espace formé au bord de l'élément de construction entre l'espaceur et les faces des vitres tournées l'une vers l'autre est entièrement rempli d'une masse d'étanchéité, qui enrobe également les fils. De cette façon, les fils sortent à l'intérieur d'une des faces principales de l'élément de construction.

Cette disposition présente l'avantage que l'espace compris entre les vitres du vitrage isolant n'est entouré que par des faces (de verre) fermées et par l'espaceur, de sorte qu'aucune mesure d'étanchéité complémentaire n'est nécessaire. Un certain inconvénient de cette configuration est la distance relativement grande de l'espaceur à l'arête de la vitre par laquelle les fils sont conduits à l'extérieur. Il y a en outre des sous-structures destinées à fixer de tels éléments de construction, avec lesquelles la position proche du bord de la sortie des fils hors de l'élément de construction est défavorable, parce qu'il n'existe aucune possibilité d'introduire les fils dans la sous-structure. De plus, le tronçon des fils de raccordement, qui est conduit jusqu'au bord de l'élément, peut dans certains cas influencer négativement l'effet visuel esthétique de l'élément de construction, s'il ne peut pas être recouvert.

Il est également connu (DE-1 278 292) de mener des fils électriques hors de l'espace compris entre les vitres d'un élément de construction en verre isolant à travers un trou foré dans une des vitres et débouchant dans cet espace ou à travers un trou foré traversant l'espaceur lui-même. Ces trous forés doivent cependant être scellés avec très grand soin en plus du collage de l'espaceur, afin que les propriétés du vitrage isolant restent garanties en permanence.

Il est aussi connu (EP-B1 0 192 472) de fixer des vitrages isolants à une sous-structure avec des attaches dites ponctuelles, dont la fixation pénètre dans l'espace compris entre les vitres. Une ou les deux vitres concernée(s) est/sont à cet effet pourvue(s) d'un trou, dans lequel une attache ponctuelle peut être engagée et être fixée avec un jeu suffisant. Un intercalaire annulaire collé peut assurer à cet endroit une étanchéité par rapport à l'espace compris entre les vitres, dont la qualité correspond à l'étanchéité périphérique obtenue par l'espaceur en forme de cadre proche du bord.

L'invention a pour objet de proposer un élément de construction du type mentionné dans l'introduction, dans lequel l'emplacement du passage des fils à travers une des faces principales peut être choisi très librement.

Conformément à l'invention, cet objectif est atteint par les caractéristiques de la revendication 1. Les caractéristiques des revendications secondaires divulguent des variantes avantageuses de cet objet.

Selon l'invention, les plaques sont avantageusement des vitres en un matériau opaque, translucide ou transparent, inorganique ou organique, notamment en verre, et peuvent être monolithiques ou feuilletées, en vitrage simple ou multiple.

Du fait que l'on mène les fils de raccordement à travers l'espace compris entre les plaques entouré par l'espaceur en forme de cadre, on admet d'une part que cet espace doit comporter une ouverture pour la sortie des fils. Cependant, on peut déjà disposer, avec l'intercalaire annulaire connu en soi, d'un accessoire éprouvé qui assure, pour un coût relativement bas, une bonne étanchéité de l'espace compris entre les plaques par rapport au trou foré, par lequel les fils de raccordement sortent de l'élément de construction. Bien entendu, le trou foré débouche également dans l'espace intérieur circonscrit par l'intercalaire annulaire. Il ne doit cependant pas forcément être positionné au centre de cet espace. La dimension intérieure libre de l'espace intérieur peut en outre être plus grande que le diamètre du trou foré, de sorte que le bord de celui-ci forme une contre-dépouille utilisable pour fixer l'élément de construction.

Un autre avantage de cette configuration est que les fils de raccordement peuvent être conduits de façon invisible sur la face arrière des éléments fonctionnels électriques hors de l'élément de construction et ne doivent pas d'abord être menés jusqu'au bord de celui-ci, où il ne se trouve en règle générale plus d'éléments fonctionnels. Ainsi, on contribue aussi à l'amélioration de l'aspect visuel esthétique des éléments de construction en question.

Dans une exécution particulièrement préférée de l'élément de construction suivant l'invention, la plaque porteuse est un composite à plusieurs feuilles, dans lequel les éléments fonctionnels sont noyés. Un trou dans la plaque du composite tournée vers l'espace compris entre les plaques doit être disposé d'une façon telle que les fils de raccordement pénètrent à travers celle-ci dans l'espace entouré par l'intercalaire annulaire. Ce trou ne doit pas forcément être en alignement avec le trou foré dans l'autre plaque. Les tolérances de fabrication peuvent à cet égard être largement dimensionnées. Après le tirage des fils de raccordement, le trou est de préférence rempli de la même masse de moulage, qui enrobe également les éléments fonctionnels électriques dans l'espace intermédiaire de la plaque feuilletée.

D'une manière générale, la fonction assurée par les éléments fonctionnels ne joue qu'un rôle secondaire dans le cadre de cette invention. Ils peuvent par exemple être des cellules solaires photovoltaïques et/ou des cellules à cristaux liquides remplissant des fonctions d'affichage ou d'ombrage. En principe, on peut également prendre en considération des éléments d'antenne ou de chauffage, qui doivent également être mis en contact électrique vers l'extérieur au moyen de fils de raccordement.

Dans un module solaire, qui peut être représenté comme une application préférée par un élément de construction conforme à l'invention, plusieurs cellules solaires photovoltaïques à couche mince ou à cristaux sont raccordées en série les unes aux autres. Chacune d'elles possède une diode de dérivation reliant directement ses deux pôles. Lors d'un ombrage local de l'une des cellules, celle-ci peut acquérir une haute résistance ohmique et ainsi bloquer le flux de courant de l'ensemble du montage en série. Si on autorisait une circulation de courant des autres cellules vers cette cellule ombragée, celle-ci pourrait s'échauffer largement au-delà de sa température normale sous l'effet de la puissance fournie. Pour empêcher cet effet, la diode de dérivation autorise un flux de courant de court-circuit lorsque la résistance interne de la cellule solaire excède la chute de tension à la diode. Un dommage persistant de cellules individuelles est ainsi empêché de façon sûre. En aval des diodes de dérivation de toutes les cellules du module, il n'y a plus que deux fils de raccordement pour la transmission de la puissance totale. Il peut ainsi être avantageux, pour la manipulation de tels éléments de construction, de réduire au minimum le nombre des fils de raccordement déjà dans l'élément lui-même par une disposition adéquate des diodes de dérivation ou d'éléments de construction comparables.

Pour atteindre cet avantage, d'autres composants électriques, comme des capteurs ou des transformateurs de mesure, et en particulier dans un module solaire les diodes de dérivation précitées pour la protection des cellules solaires, peuvent être disposés dans l'espace entouré par l'intercalaire annulaire, suivant une autre variante avantageuse de t'élément de construction conforme à l'invention.

Si nécessaire, on remplira partiellement ou complètement l'espace entouré par l'intercalaire annulaire avec une masse d'étanchéité. On évite ainsi les attaques de corrosion, à l'endroit où les fils de raccordement pénètrent dans ledit espace. Il est également possible de couvrir le trou de sortie avec un recouvrement séparé, par exemple un boîtier, et ainsi de le protéger contre des influences directes de l'environnement.

Dans une variante suivante et avantageuse, un élément d'accrochage ponctuel est fixé de façon connue en soi, dans la région de l'intercalaire annulaire, à une ou aux deux plaques de l'élément de construction. Suivant l'invention, l'élément d'accrochage ponctuel est, pour une autre fonction, pourvu d'un passage pour les fils de raccordement. Ceci peut être réalisé par exemple en perçant un trou dans l'élément d'accrochage ponctuel le long de son axe central. On peut également prévoir que les fils soient introduits d'abord à l'intérieur de l'élément d'accrochage ponctuel à travers le plan de la plaque (arrière) de l'élément de construction et ensuite radialement ou latéralement hors de l'élément de construction lui-même. Si l'élément d'accrochage ponctuel est assemblé aux deux plaques de l'élément de construction, alors on introduira les fils en direction radiale dans le passage. Dans tous les cas, l'élément d'accrochage ponctuel peut protéger efficacement les fils de raccordement dans la région critique de la sortie hors de l'élément de construction contre des dommages mécaniques pendant la manipulation sur le chantier.

Il va de soi que plusieurs passages de ce type peuvent être prévus dans un seul élément de construction, si le nombre des éléments fonctionnels électriques et/ou leur répartition dans la face de l'élément de construction devaient l'exiger. Outre la fabrication de composants standard, pour lesquels la sous-structure peut être dimensionnée au préalable, il est également possible de respecter des exigences individuelles de façon relativement simple en raison de la variabilité conforme à l'invention de l'emplacement du passage des fils.

Pour la fabrication d'un tel élément de construction, on procédera de la façon suivante :

D'abord, les éléments fonctionnels sont assemblés à la plaque porteuse et leurs fils de raccordement sont conduits hors de la plaque porteuse à l'intérieur de la face qui formera ultérieurement un côté de l'espace compris entre les plaques. L'autre plaque est pourvue du trou foré d'une façon telle que celui-ci se trouve, lors de l'assemblage ultérieur, au moins approximativement en face de l'emplacement où les fils de raccordement quittent la plaque porteuse. On réunit ensuite les deux plaques au moyen de l'espaceur en forme de cadre, l'intercalaire annulaire étant disposé entre les deux plaques à l'intérieur de l'espace compris entre les plaques et étant assemblé à celles-ci, d'une façon telle que les fils de raccordement quittant la plaque porteuse pénètrent dans l'espace entouré par l'espaceur et en sortent ensuite à travers le trou foré de l'autre plaque, tant le trou foré de l'autre plaque que la dérivation des fils de raccordement par rapport à la plaque porteuse se trouvant entièrement à l'intérieur de la surface formée par le périmètre intérieur de l'intercalaire annulaire et hermétiquement isolée de l'espace compris entre les plaques. Selon le modèle, on peut fixer en plus dans la région du trou foré de l'autre plaque une attache ponctuelle présentant un trou de passage et on mène les fils de raccordement vers l'extérieur, à travers le trou de passage, hors de l'élément de construction.

D'autres détails et d'autres avantages de l'objet de l'invention apparaîtront par le dessin de deux exemples de réalisation et par leur description détaillée qui suit.

Dans ces dessins en représentation schématique :
- la figure 1 illustre en coupe une première forme de réalisation, dans laquelle les fils de raccordement sortent directement par un trou foré dans une plaque de l'élément de construction ; et
- la figure 2 illustre en coupe une seconde forme de réalisation, dans laquelle les fils de raccordement sont menés vers l'extérieur à travers une attache ponctuelle indiquée seulement de façon schématique.

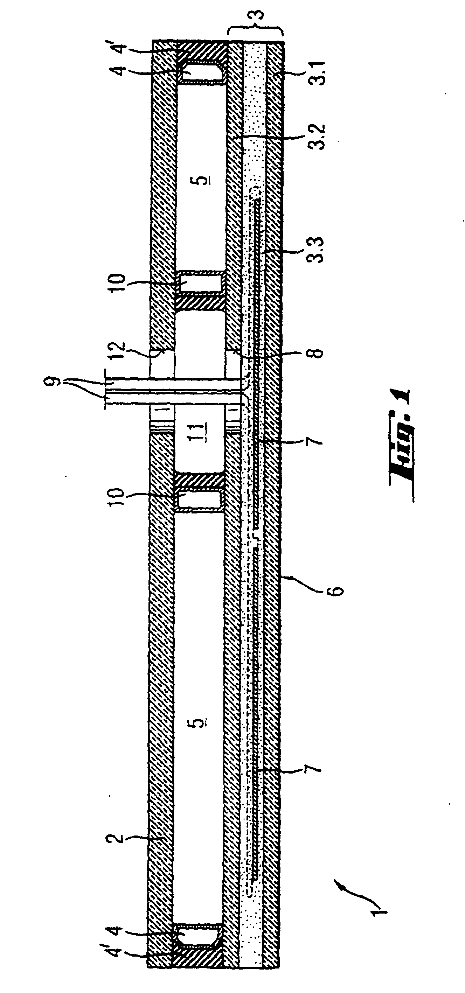

Suivant la figure 1, un élément de construction 1 est fabriqué à la manière d'un vitrage isolant à partir d'une vitre monolithique 2, d'une vitre composite 3 (vitre feuilletée) ainsi que d'un espaceur 4 en forme de cadre assemblant solidement l'une à l'autre les deux vitres 2 et 3. Ce dernier est collé hermétiquement de la façon habituelle à la périphérie des deux vitres 2 et 3 au moyen d'un adhésif, par exemple d'une colle butyle. Il circonscrit la surface latérale d'un espace 5 compris entre les vitres, dont les faces principales sont formées par les côtés internes des deux vitres 2 et 3, et il court à une faible distance du bord extérieur des deux vitres, parallèlement à leurs arêtes. La rainure périphérique qui subsiste est remplie de la façon habituelle avec une masse d'étanchéité 4', par exemple du polysulfure.

La vitre composite 3 sert en outre de vitre porteuse 6 pour des éléments fonctionnels électriques 7, ici sous la forme de cellules solaires photovoltaïques. Ceux-ci sont disposés de façon connue en soi entre deux vitres 3.1 et 3.2 et ils sont reliés électriquement en série les uns aux autres. L'espace accueillant les éléments fonctionnels entre les vitres 3.1 et 3.2 est, également de façon connue, rempli au moyen d'une masse de moulage durcie hautement transparente 3.3, qui enrobe les cellules solaires et constitue une couche de colle assemblant l'une à l'autre de façon inséparable les deux vitres 3.1 et 3.2. La couche de résine de moulage est représentée ici avec une épaisseur exagérée, pour montrer plus clairement la position de montage des éléments fonctionnels 7 et la disposition des raccordements des fils.

Dans la position de montage de l'élément de construction 1, dans laquelle il est maintenu avec des éléments d'accrochage non représentés ici, par exemple à une construction de paroi ou de toit, la vitre composite 3 avec les éléments fonctionnels électriques 7 forme en règle générale le côté extérieur, tandis que la vitre monolithique 2 est tournée vers la sous-structure. Dans ce cas d'application, seule la vitre externe 3.1 de la vitre composite 3 doit en outre être aussi transparente que possible, tandis que les vitres 3.2 et 2 peuvent avoir un revêtement opaque, teinté ou coloré. En toute généralité, on utilise cependant pour toutes ces vitres du verre clair ou un matériau synthétique correspondant.

L'épaisseur de l'espace 5 compris entre les vitres est environ 1,5 cm, la vitre composite 3 avec les éléments fonctionnels 7 a également une épaisseur d'environ 1,5 cm, et l'ensemble de l'élément de construction 1 a une épaisseur d'environ 3,5 cm. Sa surface peut varier dans de larges limites en fonction des exigences respectives, de même pour le nombre des éléments fonctionnels électriques incorporés. Les éléments d'accrochage mentionnés peuvent être disposés dans la surface de l'élément de construction (sous forme d'attaches ponctuelles) et/ou au bord de celui-ci.

La vitre 3.2 tournée vers l'espace 5 compris entre les vitres est pourvue d'un trou 8 dans la région de la face arrière de l'un des éléments fonctionnels 7. Par celui-ci, des fils de raccordement 9 partant des éléments fonctionnels sont introduits dans l'espace 5 compris entre les vitres à partir de l'espace intermédiaire du composite rempli de la masse de moulage 3.3. Le trou 8 est obturé avec la même masse de moulage 3.3 après le tirage des fils 9. Dans la région du trou 8, un intercalaire annulaire 10 est fixé entre les deux vitres 2 et 3 de l'élément de construction 1, de la même façon que l'espaceur en forme de cadre 4. Il forme la face latérale d'un espace intérieur 11, dans lequel d'une part débouche le trou 8 et d'autre part sont introduits directement les fils de raccordement 9 sortant de la vitre composite 3. L'intercalaire annulaire peut assurer en tant que tel l'étanchéité de l'espace 11. Si nécessaire, un cordon de masse d'étanchéité 4' peut à nouveau être prévu pour assurer une étanchéité supplémentaire de cet intercalaire annulaire. Cette disposition peut être prévue dans toute zone de l'espace 5 compris entre les vitres, qui entoure par conséquent de tous les côtés, radialement vers l'extérieur, l'intercalaire annulaire.

Pour simplifier, on n'a représenté ici que deux fils de raccordement. Ils sont de préférence constitués par des fils plats électriquement isolés. Il est également possible, comme on l'a déjà signalé, d'introduire dans l'espace intérieur 11 un plus grand nombre de fils de raccordement, en s'écartant de la variante représentée, et en outre d'installer encore dans celui-ci d'autres éléments fonctionnels électriques. De préférence, l'intercalaire est circulaire, ce qui n'est cependant pas forcément nécessaire. Les intercalaires annulaires 10 sont disponibles en plusieurs tailles. Les diamètres intérieurs disponibles sont actuellement compris entre 3 et 7 cm. Si nécessaire, on pourrait naturellement fabriquer aussi des anneaux plus grands, en particulier pour recevoir d'autres composants électriques.

Dans la vitre monolithique 2, il est également prévu un trou foré (fraisé) 12, qui débouche dans l'espace intérieur 11 défini par l'intercalaire annulaire 10 et qui permet la sortie des fils de raccordement 9 hors de l'élément de construction 1. Si nécessaire, tout l'espace intérieur 11 est rempli d'une masse d'étanchéité non représentée ici, qui représente une protection supplémentaire contre des attaques de corrosion sur le passage des fils de raccordement. Le trou 8, l'axe central de l'intercalaire annulaire 10 et le trou foré 12 ne doivent pas être disposés concentriquement les uns aux autres.

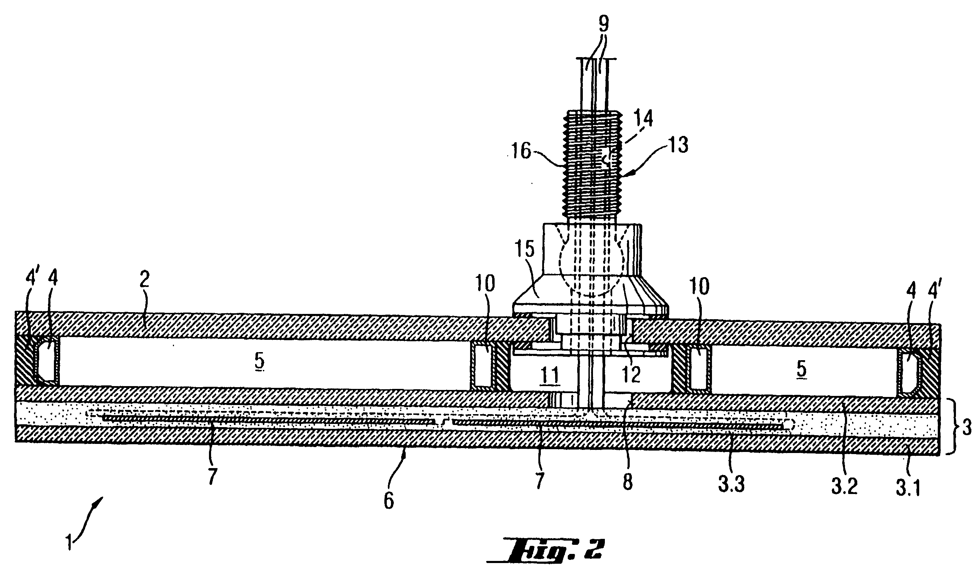

Dans la variante de la figure 2, avec une structure fondamentalement inchangée par rapport à la figure 1, une attache ponctuelle métallique 13 indiquée seulement de façon schématique est fixée, en guise de composant additionnel dans la région de l'intercalaire annulaire 11, à l'élément de construction 1 respectivement dans le trou foré 12 de la vitre monolithique 2. De la façon habituelle, des couches intermédiaires synthétiques empêchent le contact direct entre la vitre (de verre) 2 et la matière de l'attache ponctuelle 13. D'autres détails de construction de celle-ci ainsi que sa fixation à l'élément de construction ne sont au premier chef intéressants qu'au point de vue du passage des fils de raccordement 9. En particulier, l'attache ponctuelle peut aussi soutenir de façon connue les deux vitres 2 et 3, à la différence de la variante simplifiée représentée ici. Les fils 9 doivent alors éventuellement être introduits radialement dans celle-ci et poursuivis suivant la façon représentée.

Dans le cas d'application illustré ici, un trou de passage 14 s'étend le long de l'axe central de l'attache ponctuelle. Il traverse aussi bien la zone articulée 15 de celle-ci que sa tige 16 - munie d'un filet extérieur. Le trou de passage 14 est suffisamment large pour recevoir les fils de raccordement 9, qui sont ensuite menés vers l'extérieur à travers la tige 16 de l'attache ponctuelle 13 et à travers l'extrémité libre de celle-ci. De même, les fils sont suffisamment flexibles, pour pouvoir accompagner les mouvements de compensation de la zone articulée 15. L'ampleur régulière des mouvements de celle-ci est par ailleurs trop petite pour pouvoir endommager les fils de raccordement 9, par exemple par rupture de pliage.

Dans une autre variante non représentée, le passage des fils de raccordement 9 à l'intérieur de l'attache ponctuelle 13 peut également décrire un angle. On pourrait ainsi mener les fils certes en position centrée à travers le trou foré 12 à l'intérieur de l'attache ponctuelle et vers l'extérieur à travers le plan de la vitre 2, et cependant les conduire, sur leur trajet ultérieur, radialement vers l'extérieur en un endroit adéquat (par exemple à la transition entre la zone articulée et la tige). Selon le cas d'application, cette solution peut présenter des avantages par rapport à la réalisation illustrée dans la figure, en ce qui concerne le guidage ultérieur des fils de raccordement dans la sous-structure.

## Revendications

1. Elément de construction plat (1), en particulier vitrage isolant, se composant d'au moins deux plaques fixes (2, 3) et d'un espaceur (4) assemblant celles-ci solidement et avec un écartement prédéterminé et entourant d'un encadrement un espace (5) compris entre les plaques, dans lequel au moins une des plaques fixes porte des éléments fonctionnels électriques (7), en particulier des cellules solaires, dont les fils de raccordement (9) partant du côté de la plaque porteuse tourné vers l'espace compris entre les plaques sont menés vers l'extérieur à travers un trou foré (12) dans l'autre plaque (2) et les fils de raccordement (9) s'étendant à travers l'espace (5) compris entre les plaques entouré par l'espaceur en forme de cadre (4), **caractérisé en ce qu'**ils y sont entourés par un intercalaire annulaire (10), qui assemble les deux plaques (2, 3) l'une à l'autre dans la région du trou foré (12) et forme la face latérale d'un espace intérieur (11).

2. Elément de construction suivant la revendication 1, **caractérisé en ce que** la dimension intérieure libre de l'intercalaire annulaire (10) définissant l'espace intérieur (11) est plus grande que le diamètre du trou foré (12).

3. Elément de construction suivant la revendication 1 ou 2, **caractérisé en ce que** la plaque porteuse (6) est un composite à plusieurs feuilles (3), dans lequel les éléments fonctionnels (7) sont noyés et dont la feuille (3.2) orientée vers l'espace (5) compris entre les plaques présente un trou foré (8) destiné à conduire les fils de raccordement (9) hors du composite dans l'espace intérieur (11) entouré par l'intercalaire annulaire (10).

4. Elément de construction suivant l'une quelconque des revendications précédentes, **caractérisé en ce que** d'autres éléments de construction, en particulier des diodes de dérivation de cellules solaires, sont disposés dans l'espace intérieur (11) entouré par l'intercalaire annulaire (10).

5. Elément de construction suivant l'une quelconque des revendications précédentes, **caractérisé en ce que** l'espace intérieur (11) entouré par l'intercalaire annulaire est au moins en partie rempli d'une masse d'étanchéité.

6. Elément de construction suivant l'une quelconque des revendications précédentes, **caractérisé en ce qu**'une attache ponctuelle (13) pourvue d'un passage (14) pour les fils de raccordement (9) est fixée à une ou aux deux plaques (2, 3) de l'élément de construction (1) dans la région de l'intercalaire annulaire (10).

7. Procédé pour la fabrication d'un élément de construction plat composé de deux plaques assemblées l'une à l'autre par un espaceur en forme de cadre en créant un espace compris entre les plaques entouré par celui-ci, dont l'une porte des éléments fonctionnels électriques, dont les fils électriques de raccordement quittant la plaque porteuse sont menés hors de l'élément de construction à travers un trou foré dans l'autre plaque, **caractérisé par** les opérations suivantes:
- les fils de raccordement électrique sont conduits à partir de la plaque porteuse à l'intérieur de la face de celle-ci formant un côté de l'espace compris entre les plaques ;
- le trou foré dans l'autre vitre est disposé à un endroit correspondant à l'intérieur de la face de celle-ci formant l'autre côté de l'espace compris entre les plaques ;
- en plus de l'espaceur en forme de cadre, un intercalaire annulaire est disposé entre les plaques à l'intérieur de l'espace compris entre les plaques et est assemblé à celles-ci, d'une façon telle que les fils de raccordement quittant la plaque porteuse pénètrent dans l'espace intérieur entouré par l'intercalaire et en sortent à travers le trou foré de l'autre plaque, tant le trou foré de l'autre plaque que la dérivation des fils de raccordement par rapport à la plaque porteuse se trouvant entièrement à l'intérieur de la surface formée par le périmètre intérieur de l'intercalaire annulaire.

8. Procédé suivant la revendication 7, **caractérisé en ce qu'**une attache ponctuelle avec un passage formant guide est fixée à une ou aux deux plaques de l'élément de construction dans la région du trou foré de l'autre plaque et **en ce que** les fils de raccordement sont conduits vers l'extérieur, hors de l'élément de construction, à travers ce passage.

## Patentansprüche

1. Flächiges Bauelement (1), insbesondere Isolierglasscheibe, bestehend aus mindestens zwei starren Scheiben (2, 3) und einem diese fest und mit vorgegebenem Abstand miteinander verbindenden, rahmenartig einen Scheibenzwischenraum (5) umschreibenden Abstandhalter (4), wobei mindestens eine der starren Scheiben die elektrischen Funktionselemente (7) trägt, insbesondere Solarzellen, deren Anschlussleitungen (9) ausgehend von der zum Scheibenzwischenraum gewandten Seite der Trägerscheibe durch eine Bohrung (12) in der anderen Scheibe (2) nach außen geführt sind, und sich die Anschlussleitungen (9) durch den vom rahmenartigen Abstandhalter (4) umschriebenen Scheibenzwischenraum (5) erstrecken, **dadurch gekennzeichnet, dass** sie dort von einem ringförmigen Abstandhalter (10) umgeben sind, welcher die beiden Scheiben (2, 3) im Bereich der Bohrung (12) miteinander verbindet und die Mantelfläche eines Innenraums (11) bildet.

2. Bauelement nach Anspruch 1, **dadurch gekennzeichnet, dass** das den Innenraum (11) definierende freie Innenmaß des ringförmigen Abstandhalters (10) größer als der Durchmesser der Bohrung (12) ist.

3. Bauelement nach Anspruch 1 oder 2, **dadurch gekennzeichnet, dass** die Trägerscheibe (6) ein mehrschichtiger Verbund (3) ist, in dem die Funktionselemente (7) eingebettet sind und dessen zum Scheibenzwischenraum (5) weisende Scheibe (3.2) eine Bohrung (8) zum Herausführen der Anschlussleitungen (9) aus dem Verbund in den vom ringförmigen Abstandhalter (10) umschlossenen Innenraum (11) aufweist.

4. Bauelement nach einem der vorstehenden Ansprüche, **dadurch gekennzeichnet, dass** in dem vom ringförmigen Abstandhalter (10) umschlossenen Innenraum (11) weitere Bauelemente, insbesondere Bypass-Dioden von Solarzellen, angeordnet sind.

5. Bauelement nach einem der vorstehenden Ansprüche, **dadurch gekennzeichnet, dass** der vom ringförmigen Abstandhalter umschlossene Innenraum (11) wenigstens teilweise mit einer Dichtmasse ausgefüllt ist.

6. Bauelement nach einem der vorstehenden Ansprüche, **dadurch gekennzeichnet, dass** im Bereich des ringförmigen Abstandhalters (10) ein mit einer Durchführung (14) für die Anschlussleitungen (9) versehener Punkthalter (13) an einer oder beiden Scheiben (2, 3) des Bauelements (1) befestigt ist.

7. Verfahren zum Herstellen eines flächigen Bauelements aus zwei über einen rahmenförmigen Abstandhalter unter Bildung eines von letzterem umschriebenen Scheibenzwischenraums miteinander verbundenen Scheiben, deren eine elektrische Funktionselementen trägt, deren von der Trägerscheibe weggeführte elektrische Anschlussleitungen durch eine Bohrung in der anderen Scheibe aus dem Bauelement herausgeführt werden, **gekennzeichnet durch** folgende Schritte :
- die elektrischen Anschlussleitungen werden von der Trägerscheibe innerhalb deren eine Seite des Scheibenzwischenraums bildender Fläche weggeführt;
- die Bohrung in der anderen Scheibe wird an entsprechender Stelle innerhalb deren die andere Seite des Scheibenzwischenraums bildender Fläche angeordnet;
- zusätzlich zum rahmenförmigen Abstandhalter wird innerhalb des Scheibenzwischenraums ein ringförmiger Abstandhalter so zwischen den Scheiben angeordnet und mit diesen verbunden, dass die von der Trägerscheibe weggeführten Anschlussleitungen in den von ihm umschriebenen Innenraum eintreten und daraus **durch** die Bohrung der anderen Scheibe herausgeführt werden, wobei sowohl die Bohrung der anderen Scheibe als auch die Ableitung der Anschlussleitungen von der Trägerscheibe vollständig in der vom Innenumfang des ringförmigen Abstandhalters gebildeten Fläche liegen.

8. Verfahren nach Anspruch 7, **dadurch gekennzeichnet, dass** im Bereich der Bohrung der anderen Scheibe ein Punkthalter mit einer Durchführung an einer oder an beiden Scheiben des Bauelements befestigt wird und dass die Anschlussleitungen durch diese Durchführung aus dem Bauelement nach außen geführt werden.

## Claims

1. Flat construction element (1), in particular insulating glazing, composed of at least two fixed plates (2, 3) and a spacer (4) connecting these together firmly and with a predetermined separation and surrounding, with a frame, a space (5) lying between the plates, in which at least one of the fixed plates carries functional electrical elements (7), in particular solar cells, whose connecting wires (9) starting from the side of the carrier plate turned towards the space lying between the plates are brought to the outside through a hole (12) drilled in the other plate (2), and the connecting wires (9) extending through the space (5) lying between the plates surrounded by the space in the form of a frame (4), **characterised in that** they are surrounded there by an annular insert (10) which connects the two plates (2, 3) to one another in the region of the drilled hole (12) and forms the lateral face of an internal space (11).

2. Construction element according to Claim 1, **characterised in that** the free inside dimension of the annular insert (10) defining the internal space (11) is greater than the diameter of the drilled hole (12).

3. Construction element according to Claim 1 or 2, **characterised in that** the carrier plate (6) is a composite with several sheets (3), in which the functional elements (7) are embedded and where the sheet (3.2) oriented towards the space (5) lying between the plates has a drilled hole (8) intended to conduct the connecting wires (9) out of the composite into the internal space (11) surrounded by the annular insert (10).

4. Construction element according to any one of the preceding claims, **characterised in that** other construction elements, in particular solar cell bypass diodes, are disposed in the internal space (11) surrounded by the annular insert (10).

5. Construction element according to any one of the preceding claims, **characterised in that** the internal space (11) surrounded by the annular insert is at least partly filled with a sealing mass.

6. Construction element according to any one of the preceding claims, **characterised in that** a single fastener (13) provided with a passage (14) for the connecting wires (9) is fixed to one or both plates (2, 3) of the construction element (1) in the region of the annular insert (10).

7. Method for manufacturing a flat construction element composed of two plates connected to one another by a spacer in the form of a frame, creating a space lying between the plate surrounded by this, one of which carries functional electrical elements, the electrical connection wires of which leaving the carrier plate are led out of the construction element through a hole drilled in the other plate, **characterised by** the following operations:
- the electrical connection wires are led from the carrier plate inside the face thereof forming one side of the space lying between the plates;
- the hole drilled in the other pane is disposed at a point corresponding to the inside of the face thereof forming the other side of the space lying between the plates;
- in addition to the spacer in the form of a frame, an annular insert is disposed between the plates inside the space lying between the plates and is connected to these, in a manner so that the connecting wires leaving the carrier plate enter the internal space surrounded by the insert and leave it through the hole drilled in the other plate, both the holes drilled in the other plate and the bypass for the connecting wires with respect to the carrier plate being situated entirely inside the surface formed by the internal perimeter of the annular insert.

8. Method according to Claim 7, **characterised in that** a single fastener with a passage forming a guide is fixed to one or both plates of the construction element in the region of the hole drilled in the other plate and **in that** the connecting wires are led to the outside, outside the construction element, through this passage.
